(19) Europäisches Patentamt
European Patent Office
Office européen des brevets

(11) **EP 1 657 819 B1**

(12) **EUROPÄISCHE PATENTSCHRIFT**

(45) Veröffentlichungstag und Bekanntmachung des Hinweises auf die Patenterteilung:
**27.02.2013 Patentblatt 2013/09**

(51) Int Cl.:
*H03K 17/96* (2006.01)   *F24C 7/08* (2006.01)

(21) Anmeldenummer: **05022822.0**

(22) Anmeldetag: **19.10.2005**

(54) **Kochfeldsteuerung**

Cooktop control

Commande de plaque de cuisson

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **10.11.2004 DE 102004054322**

(43) Veröffentlichungstag der Anmeldung:
**17.05.2006 Patentblatt 2006/20**

(73) Patentinhaber: **ZF Friedrichshafen AG 88038 Friedrichshafen (DE)**

(72) Erfinder:
• **Grüner, Markus**
  **95506 Kastl (DE)**
• **Kraus, Thomas**
  **92281 Königstein (DE)**

(56) Entgegenhaltungen:
**EP-A- 0 994 306      EP-A- 1 288 848
WO-A-03/023701      DE-A1- 10 146 996
DE-U1- 20 008 425**

EP 1 657 819 B1

## Beschreibung

Die Erfindung bezieht sich auf eine Kochfeldsteuerung mit einer Mehrzahl von optischen Sendern und einer Mehrzahl von optischen Empfängern, die auf einem Träger abwechselnd längs einer Bedienlinie angeordnet sind, nach dem Oberbegriff des Patentanspruchs 1. Eine Steuerung nach dem Oberbegriff des Patentanspruchs 1 ist aus der DE 101 46 996 A1 bekannt.

Aus der Patentschrift DE 197 00 836 C1 ist ein optischer Sensorschalter bekannt, der für ein Glaskeramikkochfeld geeignet ist. Der bekannte Sensorschalter weist eine Lichtquelle und einen lichtempfindlichen Signalsensor auf, der an eine Schaltung angeschlossen ist und von der Lichtquelle Licht empfängt. Die Schaltung erzeugt ein Ausgangssignal, wenn der Signalsensor Licht oberhalb eines vorgegebenen Schwellwertes empfängt.

Die Lichtquelle und der Signalsensor sitzen in einem Lichtleitsockel, der mit zwei Lichtleitern ausgestattet ist. Die freien Enden der beiden Lichtleiter sind so positioniert, dass vom ersten Lichtleiter austretendes Licht durch einen in die Nähe der freien Stirnseiten zu bringenden Betätiger oder Finger Licht in den zweiten Lichtleiter reflektiert und in diesem zum Signalsensor geführt wird.

Mehrere dieser Lichtleitsockel sind auf einer Leiterplatte montiert, welche auch die angeschlossene Schaltung trägt. Die bekannten Lichtleitsockel bedingen einen verhältnismäßig großen Abstand zwischen dem Glaskeramikkochfeld und der darunter liegenden Leiterplatte.

In der älteren deutschen Anmeldung DE 10 2004 024 835.4 ist eine Kochfeldsteuerung vorgeschlagen worden, bei der - anders als bei den optischen Sensorschaltern gemäß dem Patent DE 197 00 836 C1 - ein Fototransistor und eine Leuchtdiode nicht unbedingt ein festes Paar bilden müssen. Beispielsweise kann gemäß dem älteren Vorschlag eine schmale oder schlanke Bedienlinie dadurch erhalten werden, dass die Leuchtdioden und die Fototransistoren abwechselnd auf der Bedienlinie angeordnet werden. Eine breitere Bedienlinie ergibt sich, wenn die Leuchtdioden in einem bestimmten Winkel zur Reihung der Fototransistoren neben der Bedienlinie angeordnet sind; in diesem Fall kann auch je eine Reihe von Leuchtdioden links und rechts neben der Bedienlinie angeordnet sein, um jeweils ein Tripel mit einem Fototransistor zu bilden.

Jedoch hält die ältere Anmeldung auch weiterhin daran fest, dass die Sensoren entweder in Lichtleitsockeln gemäß der DE 197 00 836 C1 oder in einem größeren Kunststoffteil für mehrere Leuchtdioden und Fototransistoren angeordnet sind. Diese Lichtleitsockel oder Kunststoffteile sind mit Lichtleitern ausgestattet, um eine sichere Leitung des an der Fingerkuppe reflektierten Lichts zu ermöglichen und Streulicht möglichst zu vermeiden. Die Erfindung hat demgegenüber erkannt, dass das Streulicht nicht unbedingt mithilfe der Lichtleitsockel vermieden werden muss, um eine genaue Positionserkennung der Fingerkuppe zu erzielen. Im Gegenteil kann die Lichtstreuung des von einem optischen Sender ausgesandten Lichtes auf mehrere Empfänger zugelassen und dadurch sogar eine noch bessere Positionsauflösung erreicht werden.

Die Erfindung hat sich daher die Aufgabe gestellt, bei Kochfeldsteuerungen der eingangs beschriebenen Art die Bauhöhe des mit den optischen Komponenten bestückten Trägers zu verringern und die Positionsauflösung der reflektierenden Fingerkuppe zu erhöhen.

Diese Aufgabe wird durch eine Kochfeldsteuerung mit den Merkmalen des Patentanspruchs 1 gelöst. Erfindungsgemäß wird der jeweilige Lichteinfall auf alle optischen Empfänger einer Bedienlinie ausgewertet und so eine aktuelle Position des Fingers auf der Bedienlinie berechnet. Es wird also gerade das von einer oder mehreren Lichtquellen ausgehende und vom Finger reflektierend gestreute Licht ausgewertet, um die Position des Fingers zu bestimmen. Die Erfindung hat erkannt, dass diese Lichtverteilung auf der Mehrzahl von optischen Empfängern ausreichend ist, um die Position des Fingers - beispielsweise als Schwerpunkt der Intensitäten des empfangenden Lichtes - zu messen.

Zweckmäßige Weiterbildungen und zusätzliche Erfindungsgedanken sind in den abhängigen Ansprüchen enthalten.

Erfindungsgemäß werden die optischen Sender mit Impulsen angesteuert, was gestaffelt (im Zeitmultiplex) geschieht.

Wenn die optischen Sender gleichzeitig (simultan) ihre Lichtsignale aussenden, dann entsteht durch die Reflexion an der Fingerkuppe eine Lichtverteilung, die in der Umgebung des Fingers die höchste Intensität aufweist. Aus dieser Lichtverteilung kann die Position des Fingers mit größerer Genauigkeit berechnet werden als es durch die feste Kopplung eines Senders an einen Empfänger möglich war. Denn die örtliche Auflösung ist im Stand der Technik durch den Abstand zwischen einem Lichtleitsockel und dem nächsten Lichtleitsockel gegeben.

Erfindungsgemäß wird die Verteilung des reflektierten Lichts im Zeitmultiplex gemessen, indem die Mehrzahl der optischen Sender nacheinander mit kurzen Impulsen angesteuert wird, wobei die Mehrzahl der optischen Empfänger jeweils gleichzeitig für jeden der Sender aktiviert wird. Diese Ansteuerung eröffnet die Möglichkeit, die Anzeigeelemente der Kochfeldsteuerung einzusparen. Während man also im erstgenannten Fall üblicherweise mit Infrarotlicht für die optischen Sender und Empfänger sowie mit Anzeigeelementen (also für das menschliche Auge sichtbarem Licht) in den Zwischenpositionen der optischen Infrarotkomponenten arbeitet, kann man bei dem Ausführungsbeispiel der Erfindung durchgehend mit sichtbarem Licht arbeiten und die Lichtsender gleichzeitig als Anzeigeelemente einsetzen. Für diese Lösung eignet sich die genannte Ansteuerung mit kurzen, für das Auge einer Bedienperson unsichtbaren Impulsen für Steuerzwecke und die gleichzeitige Aktivierung der optischen Empfänger für Sensorzwecke. Für den Anzeigezweck wird die Mehrzahl der Lichtsender abhängig von der aktuellen Position des Fingers auf der Bedienlinie in zwei Gruppen geteilt. Die eine Lichtsendergruppe wird mit zusätzlichen Impulsen angesteuert (zusätzlich zu den im Zeitmultiplex zwar für die optischen Empfänger, aber nicht für das menschliche Auge bestimmten Impulsen), wobei die zusätzlichen Impulse diese Lichtsendergruppe für das Auge der Bedienperson sichtbar machen. Beispielsweise leuchten auf der Bedienlinie links von der letzten aktuellen Bedien-oder Betätigungsposition des Fingers die Lichtsender auf und zeigen so die eingestellte Heizintensität des Kochfelds an.

Eine weitere von der Erfindung ermöglichte Alternative besteht darin, dass die optischen Komponenten (Sender und Empfänger) entweder mit kleiner Bauhöhe auf der Oberseite der Leiterplatte oder durch Aussparungen im Trägermaterial sichtbar auf der Unterseite der Leiterplatte angeordnet werden. Die Aussparungen können als großes Langloch für die Mehrzahl der optischen Sender und Empfänger ausgebildet sein oder die Aussparungen können als Bohrung oder kleines Langloch im Trägermaterial für jede der optischen Komponenten ausgebildet sein.

Mehrere Ausführungsbeispiele der Erfindung werden nachfolgend anhand von Abbildungen erläutert.

Abbildung 1 zeigt eine schematische Darstellung des Lichteinfalls, der von einer Mehrzahl von Sendern über eine Reflexion an einem Betätiger oder Finger zu einer Mehrzahl von Empfängern führt, welcher bei der erfindungsgemäßen Kochfeldsteuerung benützt wird;

Abbildung 2 und Abbildung 3 zeigen für zwei verschiedene Stellungen des Betätigers oder Fingers eine Signalverteilung des Lichteinfalls auf eine Mehrzahl von Sensoren, wobei als Sensor die Nachbarschaft eines Senders und eines Empfängers angesehen wird;

Abbildung 4 zeigt eine Formel zur Berechnung der aktuellen Fingerposition als Schwerpunkt der Lichtsignalverteilungen, wie sie beispielsweise in Abbildung 2 oder Abbildung 3 dargestellt sind;

Abbildungen 5A bis 5C zeigen eine Aufsicht auf die optischen Komponenten, Sender und Empfänger, sowie eine Aufsicht auf einen Träger (Leiterplatte) sowie eine Schnittansicht von der schmalen Seite des Trägers, wobei die optischen Komponenten (Sender und Empfänger) in einer vorgegebenen Mehrzahl abwechselnd längs einer Bedienlinie angeordnet sind, und zwar nach einem ersten Ausführungsbeispiel der Erfindung auf der Oberseite des Trägers;

Abbildung 6 zeigt einen Lichtleitsockel und ein Anzeigeelement nach dem Stand der Technik;

Abbildung 7 zeigt eine zweite Ausführungsform der Erfindung, bei der die optischen Sender und Empfänger (und auch die Anzeigeelemente) auf der Unterseite des Trägers angeordnet sind;

Abbildung 8 zeigt eine nicht beanspruchte Kochfeldsteuerung, bei der die Anzeigeelemente (sichtbares Licht) in Zwischenpositionen zwischen den optischen Komponenten (Infrarot-Sender und Infrarot-Empfänger) angeordnet sind;

Abbildung 9 zeigt eine erfindungsgemäße Anordnung, bei der die optischen Komponenten (Sender und Empfänger) mit Wellenlängen im sichtbaren Bereich arbeiten und die optischen Sender gleichzeitig als Anzeigeelemente benutzt werden;

Abbildungen 10A und 10B zeigen zwei Aufsichten auf die unten liegende Reihe von Komponenten gemäß Abbildung 7, wobei die Aussparung im Trägermaterial alternativ als einziges großes Langloch oder als Reihe von kleineren Öffnungen ausgebildet sein kann;

Abbildungen 11 A und 11 B zeigen zwei Zeitdiagramme von gesendeten, reflektierten und empfangenen Lichtimpulsen, wobei das obere Zeitdiagramm eine Steuerung des Empfängers ohne sichtbare Anzeige und das untere Diagramm eine Steuerung des Empfängers mit zusätzlichen Impulsen für eine Sichtanzeige darstellen.

Abbildung 12 zeigt mögliche Sensoranordnungen und beispielhafte Bedruckungen einer Kochfeld-Glasscheibe für einen kleinen Schieberegler.

Abbildung 13 zeigt unterschiedliche Verteilungen der Signalstärken für unterschiedliche Fingerpositionen, wenn die Sensoren S1 und S2 als kleiner Schieberegler im Sinne der Abbildung 12 angeordnet sind.

Abbildung 14 zeigt drei Beispiele für mögliche Bedruckungen der Glasplatte unter Nutzung von virtuellen Sensoren, die auf der Bedienlinie eines kleinen Schiebereglers definiert sind.

Abbildung 15 zeigt eine Erweiterung einer eindimensionalen Bedienlinie zu einem zweidimensionalen Bedienfeld samt der zugehörigen Anordnung der Bauteile und der virtuellen Sensoren.

Abbildung 16 zeigt drei mögliche Bedruckungen der Glasplatte, unter der ein zweidimensionales Bedienfeld gemäss Abbildung 15 unterlegt ist.

Für Kochfeldsteuerungen ist es üblich, bestückte Leiterplatten direkt unterhalb eines Glaskeramik-Kochfelds zu montieren. Die Leiterplatte dient als Träger sowohl für Anzeigeelemente, welche die Größe der eingestellten Heizleistung anzeigen, als auch für optische Komponenten, die für die Einstellung der Heizleistung da sind. Die optischen Komponenten sind zweckmäßigerweise längs einer Bedienlinie auf dem Träger angeordnet.

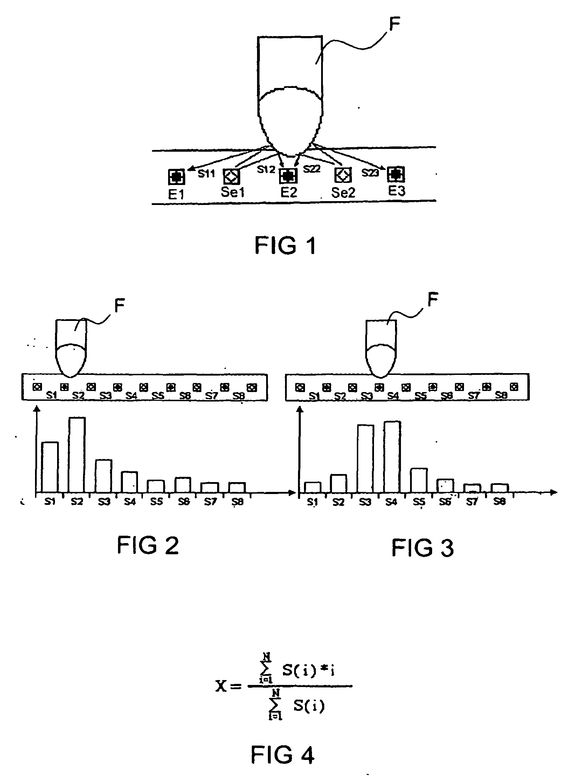

Zur Steuerung von modernen Kochfeldern wird der Finger einer Bedienperson benutzt, der durch Reflexion von Lichtstrahlen die Reihe von optischen Komponenten längs der Bedienlinie betätigt und dadurch auch zu einer geeigneten Sichtanzeige führt. Als physikalischer Effekt für die Steuerung wird die Reflektion von Lichtstrahlen benützt, die von optischen Sendern, in der Regel Leuchtdioden, ausgehen und nach dem Reflexionsvorgang von den optischen Empfängern, in der Regel Fototransistoren, empfangen und verarbeitet werden. Die vorliegende Erfindung versucht nun nicht, wie eingangs als Stand der Technik dargestellt, verstreute Reflexionen zu verhindern, sondern nutzt sämtliche Reflexionen, auch wenn sie nicht von benachbarten optischen Komponenten stammen. In Abbildung 1 ist beispielhaft der Strahlengang des Lichtes von zwei Sendern Se1 und Se2 auf drei Empfänger E1, E2 und E3 dargestellt. Jeder Sender Se1, Se2 bedient mindestens zwei Empfänger und analog wird auch jeder Empfänger von mindestens zwei Sendern bedient.

In den Abbildungen 2 und 3 sind zwei typische Signalverteilungen der Sensoren S1 bis S8 dargestellt. Als Sensor S wird in diesem Fall die Nachbarschaft eines Senders und eines Empfängers bezeichnet, wobei sich die dargestellten Intensitäten jedoch als Lichteinfall auf acht Empfänger deuten lassen. In Abbildung 2 betätigt der Finger F die Steuerung weiter links als in Abbildung 3. Schon eine kleine Änderung der Fingerposition führt zu einer merklichen Änderung der Signalverteilung. Diesen Effekt macht sich die Erfindung zunutze.

Die Abbildung 4 zeigt eine allgemeine Formel zur Berechnung des Schwerpunktes der reflektierten Lichtverteilung. Es ist davon auszugehen, dass dieser Schwerpunkt die tatsächliche Position der Fingerkuppe mit großer Genauigkeit wiedergibt. Als Ergebnis dieser Berechnung des Schwerpunktes der Lichtverteilung längs der Bedienlinie ist es möglich, viele Zwischenpositionen zwischen den Empfängern zu berechnen und dadurch eine größere Auflösung zu erreichen. Das Ergebnis X liefert einen Wert zwischen 1 und N (N Empfänger vorausgesetzt) und kann durch geeignete Normierung auf einen anderen Wertebereich transformiert werden. Die Auflösung ist dabei abhängig von der Quantisierung der Sensorsignale. Im Unterschied zur bisherigen Auswertung können aber wesentlich mehr Zwischenpositionen berechnet werden.

Bei der bisherigen Auswertung, die auf einer Reflexion mittels Lichtleitsockeln beruhte, wurden nur deutliche Signale gewertet. Um vernünftige Ergebnisse zu bekommen, wurden kleine Signale mit Quantisierungswerten von 1, 2 oder 3 nicht berücksichtigt. Bei der bisherigen Auswertung mit N Sensoren wurden alle Einzelbetätigungen gewertet, die darauf beruhten, dass nur bei einem der N Sensoren der Schwellwert überschritten wurde. Außerdem wurden noch Doppelbetätigungen gewertet, wenn bei zwei nebeneinander liegenden Sensoren die Betätigungsschwelle überschritten wurde. Bei dieser Auswertung konnten bestenfalls die Konditionen 1 und 1,5 und 2 und 2,5 und 3 und 3,5 usw. bis N unterschieden werden. Mit dieser Methode des Standes der Technik konnten bei N Sensoren also 2N-1 Positionen eindeutig detektiert werden. Die Schwerpunktsberechnung gemäß der Formel in Abbildung 4 ermöglicht es, deutlich mehr Zwischenpositionen zu berechnen. Beispiel:

## Signalverteilung S (i) =[0,0,2,5,6,1,0,0], Zahl der Sensoren N = 8

Nach der bisherigen Auswertung ergab sich ein Positionswert von X =4,5. Die kleinen Signalwerte 0, 2 und 1 tragen zu dieser Auswertung nichts bei.

Das Ergebnis der neuen Auswertung wäre für dieses Beispiel (Formel in Abbildung 4) X =62/14 =4,43.

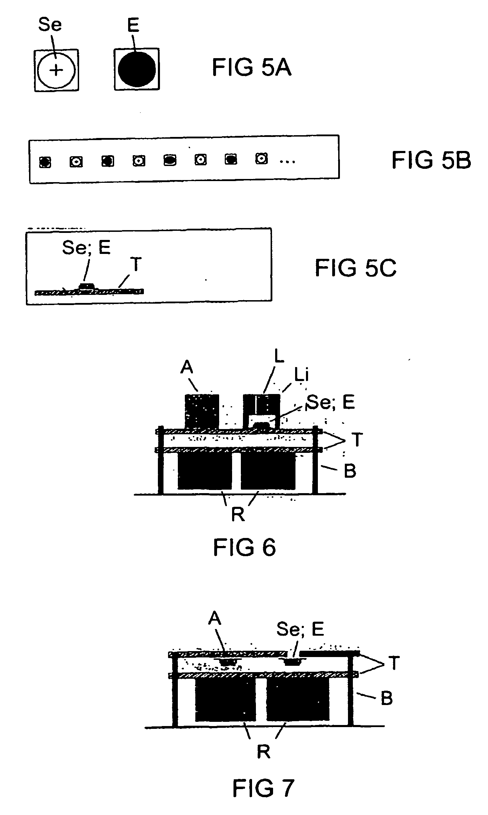

Um diese verbesserte Positionsauflösung zu erreichen, genügt die gegenüber dem Stand der Technik vereinfachte Struktur gemäß Abbildung 5A bis 5C. Die Abbildung 5B zeigt in der Aufsicht eine Reihe von optischen Sendern und Empfängern, die auf einem Träger längs einer Bedienlinie montiert sind. Die Bedienlinie kann eine Gerade sein, wie in Abbildung 5B dargestellt, sie kann jedoch auch eine andere Form annehmen.

Der Seitenschnitt durch die tragende Leiterplatte gemäß Abbildung 5C zeigt, dass die optischen Komponenten, also der Sender Se oder der Empfänger E nach einer ersten Ausführungsform der Erfindung auf der Oberseite des Trägermaterials T angeordnet sein können. Die Bauhöhe gegenüber dem Stand der Technik, der in Abbildung 6 dargestellt ist, ist wesentlich geringer, weil auf die früher benutzten Lichtleitsockel Li verzichtet wird.

Auch das zweite Ausführungsbeispiel der Erfindung gemäß Abbildung 7 zeigt eine sehr geringe Bauhöhe, weil die optischen Komponenten (Sender Se und Empfänger E) sogar auf die Unterseite der tragenden Leiterplatte verlegt werden können. In diesem Fall werden auch gleichzeitig die Anzeigeelemente A, die in der Regel von Leuchtdioden oder 7-Segmentanzeigen gebildet werden, auf der Unterseite der Leiterplatte angeordnet. Für den optischen Reflexionsweg vom Sender zum Empfänger sind in diesem Fall Aussparungen im Trägermaterial T vorgesehen (vgl. Abbildung 7). In den Abbildungen 6 und 7 sind mit Bezugszeichen B Befestigungsbolzen, mit Bezugszeichen L ein Lichtleiter und mit Bezugszeichen R Relais dargestellt.

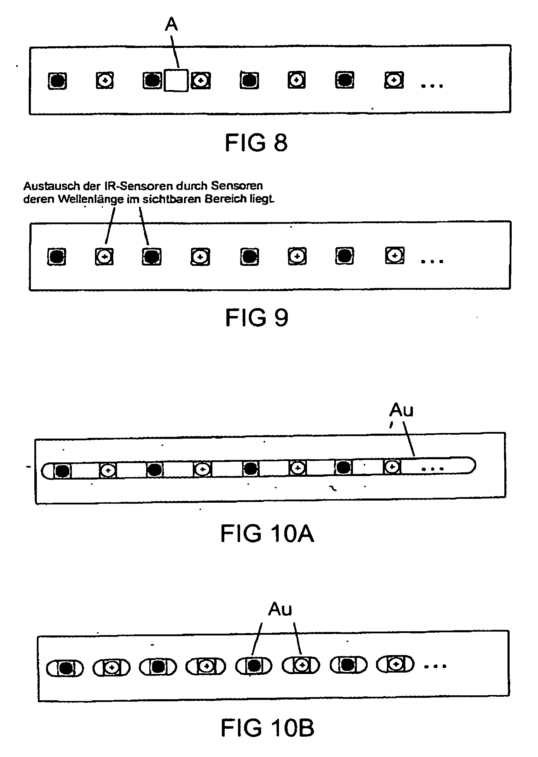

Die Abbildungen 10A und 10B zeigen zwei Möglichkeiten für solche Aussparungen Au. In der Abbildung 10A ist die Reihe von optischen Komponenten unterhalb eines Langlochs Au angeordnet, das sich über die Bedienlinie erstreckt. In der Abbildung 10B ist alternativ ein kleineres Langloch Au pro optischer Komponente vorgesehen. Es kann auch eine Reihe von Bohrungen genügen.

Anhand der Abbildungen 8 und 9 wird noch eine Alternative entwickelt, die sich auf die Anzeigeelemente A bezieht. Die Anzeigeelemente A dienen dazu, den eingestellten Parameter für die Bedienperson sichtbar anzuzeigen. Im Falle der Abbildungen 8 und 9 wird eine analoge Darstellung in Form eines Balkens oder "Bargraph" gewählt.

Die Darstellung in den Abbildungen 8 und 9 schließt an die Ausführungsform gemäß Abbildung 5B an, bei der die optischen Komponenten mit kleiner Bauhöhe auf der Oberseite des Trägermaterials angeordnet sind. Die folgende Darstellung gilt jedoch ebenfalls für die unten liegenden Komponenten gemäß Abbildung 7.

In der Abbildung 8 ist die Bedienlinie gemäß Abbildung 5B dadurch ergänzt, dass an den Zwischenpositionen zwischen je zwei optischen Komponenten (welche in diesem Fall Infrarotsensoren darstellen) Anzeigeelemente A angeordnet sind. Die Anzeigeelemente A stören aufgrund ihrer kürzeren Wellenlänge die Sensoren nicht, während die Infrarotsensoren aufgrund ihrer längeren Wellenlänge zu keiner sichtbaren Anzeige führen.

Erfindungsgemäß werden gemäß Abbildung 9, die in ihrer Struktur mit Abbildung 5B übereinstimmt, Sensoren mit Licht im sichtbaren Bereich verwendet. Dadurch kann eine Einsparung von Komponenten erreicht werden, da das optische Anzeigeelement gleichzeitig als optischer Sender fungiert. Die Anzeige wird dabei als "Bargraph" eingesetzt und mit entsprechenden Pulspaketen angesteuert. Bei einer höheren Dichte des Pulspaketes wird das Licht der Leuchtdiode sichtbar, während es bei einer geringeren Pulspaketdichte (steuerbar durch Pulsweitenmodulation PWM) unsichtbar bleibt. Die Sensorauswertung wird durch Zeitmultiplex und Synchronisation mit den Empfängern erreicht, d.h. die Leuchtdioden werden nacheinander in Zeilenrichtung angesteuert und die Empfänger werden in diesen Zeitfenstem aktiv geschaltet.

Die Reihe von Leuchtdioden als Stufenindikator oder Bargraph ist dem oben genannten Zeitmultiplex überlagert, d.h. eine anzeigeaktive Leuchtdiode wird fast permanent mit Impulspaketen angesteuert. Da die Empfänger zu diesen für die Anzeige relevanten Zeitpunkten ausgeschaltet sind, wird der Steuervorgang nicht beeinträchtigt.

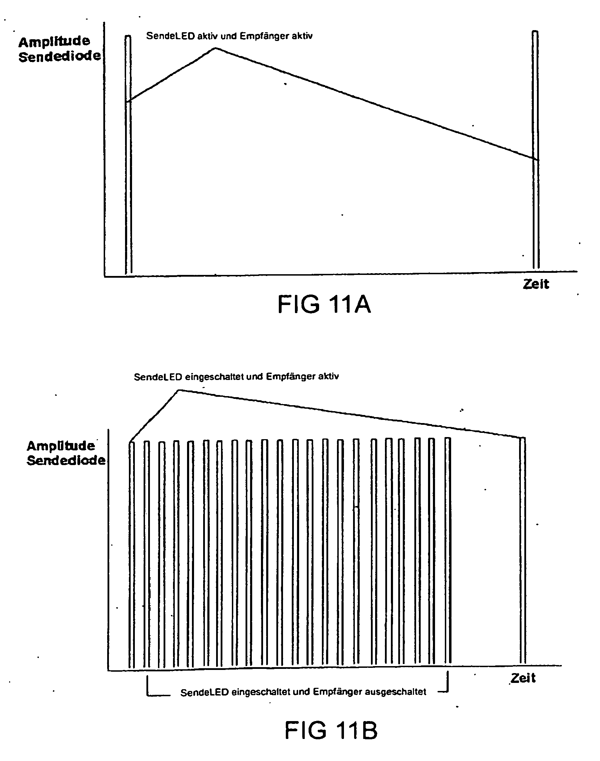

Bei dieser Ausführungsform werden also die Leuchtdioden, die sichtbares Licht abstrahlen, in zwei Gruppen eingeteilt, die von der Position des Betätigers oder Fingers abhängen. Für den Steuer-und Einstellvorgang wird nur die Impulsfolge benutzt, die in Abbildung 11A dargestellt ist. Diese kurzen Lichtimpulse sind für das menschliche Auge nicht sichtbar, erlauben jedoch dem Empfänger, die reflektierte Lichtintensität festzustellen. Diese Ansteuerung erfährt beispielsweise die Gruppe von Leuchtdioden, die sich rechts vom Finger auf der Bedienlinie befindet.

Die andere Gruppe von Leuchtdioden, die sich beispielsweise links von der Fingerkuppe auf der Bedienlinie befindet, erfährt die in Abbildung 11B dargestellte Ansteuerung. Dieses Impulspaket lässt den Sender für das menschliche Auge sichtbar werden und zeigt als Bargraph an, welche zugehörige Heizleistung durch die Fingerbetätigung eingestellt wurde.

Die anhand der verschiedenen Ausführungsbeispiele dargestellten Alternativen können strukturell und funktionell untereinander kombiniert werden.

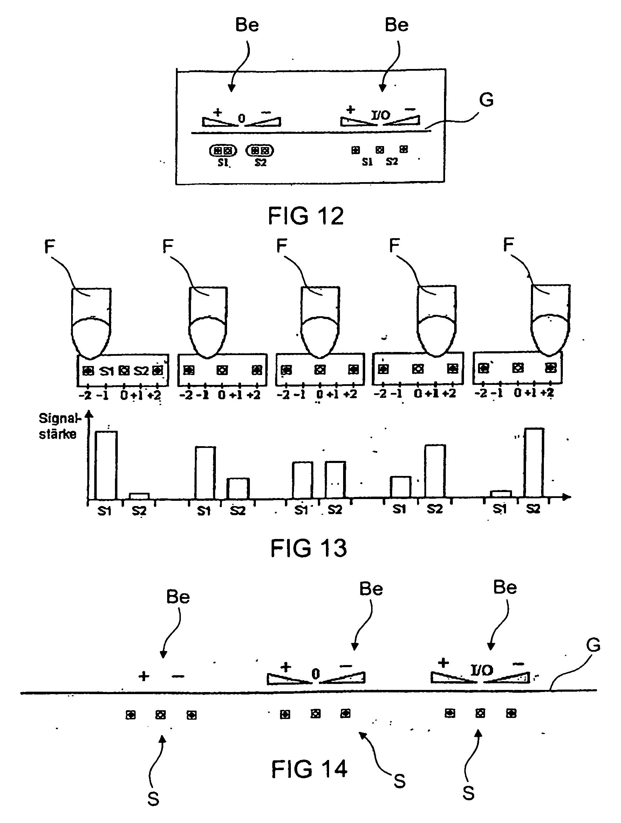

Anhand der Abbildungen 12 bis 16 werden nun weitere Ausführungsformen einer Kochfeldsteuerung erläutert, die auf dem erfindungsgemäßen Prinzip der unterscheidbaren Zwischenpositionen beruhen. Dieses Prinzip umfasst optische Sender und Empfänger, die auf der Bedienlinie abwechselnd angeordnet sind, sowie eine rechnerische Auswertung der Intensitätsverteilung auf allen Empfängern.

In den bisherigen Ausführungsbeispielen wurden direkt bedienbare Schieberegler vorgestellt, bei denen eine Anzahl N von beispielsweise 8 Abständen (Sensoren) zwischen 9 Komponenten auf einer relativ langen Bedienlinie verteilt sind. Die lange Bedienlinie erlaubte außer dem geradlinigen Schieberegler auch einen kreisförmigen Verlauf als Drehregler oder eine anderweitig gekrümmte Bahn für die Fingerbewegung. In den nachfolgenden Ausführungsbeispielen ist die Bedienlinie kurz; es sind nur N = 2 Sensoren auf ihr angeordnet. Der folgende Teil der Lösung wird daher als "kleiner Schieberegler" bezeichnet.

Es wurde gefunden, dass auch ein kleiner Schieberegler mindestens 5 (bis hin zu 10) Zwischenpositionen ausreichend sicher unterscheiden und mit Hilfe der Schwerpunktsformel nach Abbildung 4 auflösen kann. Bei den bisher im Stand der Technik bekannten diskreten Auswerteschaltungen konnten mit N = 2 Sensoren allenfalls drei Fingerpositionen unterschieden werden, nämlich eine Einzelbetätigung des Sensors S1, eine Doppelbetätigung der zwei benachbarten Sensoren S1 und S2 und eine Einzelbetätigung des Sensors S2.

Zunächst werden anhand der Abbildung 12 mögliche Anordnungen der zwei Sensoren S1 und S2 für den kleinen Schieberegler erläutert. Die Sensoren liegen unter einer Glasplatte G des Kochfelds. Dargestellt ist symbolisch die Erstreckung der kurzen Bedienlinie S1-S2 unterhalb der Glasplatte G; nicht dargestellt ist der Träger, auf dessen Oberseite (Abbildungen 5 und 9) oder Unterseite (Abbildungen 7 und 10) die Komponenten Sender und Empfänger befestigt sind. Die auf der Oberseite der Glasplatte G sichtbare Bedruckung Be wird später erläutert. Diese Bedruckung Be entspricht den jeweiligen Funktionen des Kochfelds, die den beispielsweise fünf sicher unterscheidbaren Zwischenpositionen auf der kurzen Bedienlinie S1-S2 in vielgestaltiger Weise zugeordnet werden können.

In dem Beispiel auf der rechten Seite der Abbildung 12 wird die Bedienlinie von drei Bauteilen, nämlich von zwei optischen Empfängern außen und einem optischen Sender in der Mitte gebildet. Bei IR- oder optischen Berührungsschaltern wird traditionell ein Sender und ein Empfänger zusammengenommen als Einzelsensor bezeichnet. Diese Bauform ist in Abbildung 12 links zum Vergleich als zwei Einzelsensoren S1 und S2 dargestellt. Die drei Komponenten in Abbildung 12 rechts wirken funktional ebenso wie zwei solche Einzelsensoren. Der Lichteinfall des mittigen Senders auf den linken Empfänger erzeugt ein Sensorsignal S1, während sein Lichteinfall auf den rechten Sender als Sensorsignal S2 gemessen werden kann. Das später zu beschreibende Beispiel in Abbildung 13 zeigt die Verteilung der Signalstärken auf die Sensoren S1 und S2 für fünf verschiedene Positionen des reflektierenden Finger.

Zurückkehrend zu der Abbildung 12 sind in dem alternativen Beispiel auf der linken Seite die zwei Einzelsensoren S1 und S2 nebeneinander dargestellt. Solche Sensoren sind in einem gemeinsamen Gehäuse erhältlich, wobei für die Erfindung wesentlich ist, dass die Lichtstreuung längs der Bedienlinie S1-S2 nicht etwa durch Lichtleitsockel (oder andere Abschirmungen nach dem Stand der Technik) behindert wird. Vielmehr ist eine Lichtstreuung gewollt. Unter dieser Voraussetzung wurde gefunden, dass auch die zwei Einzelsensoren (also auch die zwei dargestellten IR-Sensorpaare in den niedrigen Gehäusen) eine Verteilung der Signalstärken S1 und S2 etwa wie in Abbildung 13 liefern.

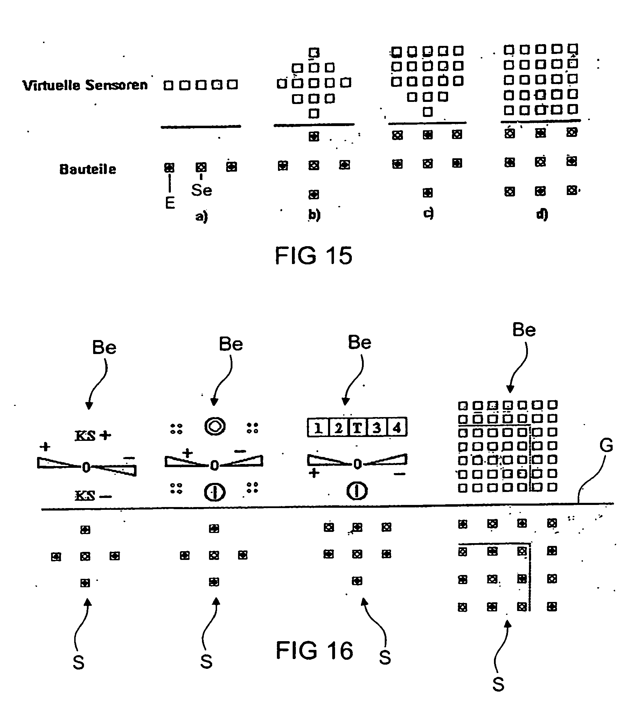

Eine weitere Variante eines kleinen Schiebereglers kommt wiederum mit drei Bauteilen aus, dieses Mal bestehend aus einem Empfänger in der Mitte und zwei Sendern außen. Diese Variante ist in Abbildung 12 nicht dargestellt; jedoch wird später von ihr anhand der Abbildungen 15 und 16 Gebrauch gemacht. In diesem Fall werden die Sender nacheinander aktiviert. Wie bereits in Abbildung 11 oben dargestellt, ist zu einem ersten Zeitpunkt der linke Sender zusammen mit dem Empfänger aktiv (funktional betrachtet Sensor S1) und zu einem zweiten Zeitpunkt der rechte Sender zusammen mit dem Empfänger aktiv (funktional betrachtet Sensor S2). Auch mit diesen drei Komponenten - so wurde experimentell gefunden - ergibt sich ein Verhältnis der Signalstärken, das ähnlich wie in Abbildung 13 einen Rückschluss auf die Position des Fingers innerhalb der definierten kurzen Bedienlinie zulässt.

Nachfolgend wird dargelegt, wie die Schwerpunktsformel gemäß Abbildung 4, ausgehend von einer langen Bedienlinie, auch bei dem kleinen Schieberegler zur Bestimmung der Fingerposition führt. Anhand der Abbildungen 2, 3 und 4 ist eingangs ein langer Schieberegler mit beispielsweise N = 8 Sensoren beschrieben worden, der zur Feineinstellung einer Heizstufe oder einer Garzeit (Timer) geeignet ist. Dabei waren vier Empfänger zwischen fünf Sender geschachtelt. Bei der Messung im Zeitmultiplex bedient ein Sender hauptsächlich zwei benachbarte Empfänger (die Randsender bedienen nur einen Empfänger), so dass acht Signalstärken S1 bis S8 gemessen und in die Schwerpunktsformel gemäß Abbildung 4 eingesetzt werden können. Das Rechenergebnis (z. B. X = 4,43) wurde gedeutet als Einstellposition des Schiebereglers, dessen Wertebereich sich proportional längs des Laufindex von i = 1 bis i = 8 erstreckt.

Bei dem kleinen Schieberegler (N = 2) ist es oft zweckmäßig, den Wertebereich des Laufindex i so zu transformieren, dass eine geometrische Mittelposition auf der Bedienlinie einem neutralen Wert i = 0 entspricht und eine geometrische Abweichung nach links (bzw. nach rechts) einem negativen Wert i = -1 (bzw. einem positiven Wert i = +1) entspricht. Für diesen Spezialfall vereinfacht sich die Schwerpunktsformel gemäß Abbildung 4 zu folgendem Ausdruck:

$$X = \frac{\sum\limits_{i=-1}^{i=+1} S(i) * i}{\sum\limits_{i=-1}^{i=+1} S(i)} = \frac{S(-1)*(-1) + S(+1)*(+1)}{S(-1) + S(+1)} = \frac{-S1 + S2}{S1 + S2} = \frac{-S1/S2 + 1}{S1/S2 + 1}$$

Es kommt also auf das Verhältnis S1/S2 der Signalstärken an, d. h. wenn die Signale der beiden Sensoren zueinander ins Verhältnis S1/S2 gesetzt werden, kann damit eine Aussage über die Stellung X des Fingers relativ zur Mittelposition X = 0 gemacht werden. In der Mittelposition i=0 sind die Signalstärken S1 und S2 gleich gross und der Rechenwert beträgt X=0. In der Praxis können aufgrund der für S1 und S2 erreichbaren Messgenauigkeiten mindestens fünf unterscheidbare Positionen X im Wertebereich von i =-1 bis i = +1 detektiert werden.

In Abbildung 13 ist das bevorzugte Beispiel dargestellt, in dem der Wertebereich des Laufindex der zwei Sensoren transformiert ist in diese fünf unterscheidbaren Fingerpositionen x =-2, x =-1, x =0, x =+1 und x =+2 längs der Bedienlinie. Solche Streckungen einer Skala durch Multiplikation mit einem Faktor sind dem Fachmann geläufig. Die Streckung dient hier dazu, die höhere Auflösung längs der Bedienlinie durch ganzzahlige Werte x auszudrücken. Während die im Stand der Technik erreichbare Auflösung durch die Skala der Sensoren i =-1 (Einzelbetätigung des linken Sensors), i = 0 (Doppelbetätigung beider Sensoren) und i = +1 (Einzelbetätigung des rechten Sensors) beschrieben wird, wird die erfindungsgemäß höhere Auflösung durch die ganzzahlige Skala der Fingerpositionen von x = -2 bis x = +2 ausgedrückt.

Wie Abbildung 13 zeigt, werden die beiden Sensoren S 1 und S2 je nach Position des Fingers F im nutzbaren Bereich unterschiedlich beaufschlagt. Wenn sich der Finger F von links nach rechts bewegt, so nimmt die Signalstärke S1 des ersten Sensors kontinuierlich ab während die Signalstärke S2 des zweiten Sensors kontinuierlich zunimmt. Nach der erläuterten Skalentransformation erhält man aus dem Verhältnis der Signalstärken S1/S2 fünf Werte x, die gut reproduzierbar zwischen -2 und +2 liegen.

Der kleine Schieberegler kann in vielfältiger Weise für Steuerungsfunktionen des Kochfelds genutzt werden. Da die Erfassung und rechnerische Weiterverarbeitung der Sensorsignale S1 und S2 prinzipiell nur durch die Quantisierung in dem auswertenden Mikroprozessor begrenzt sind, kann der quasi-kontinuierliche Rechenwert x für den Übergang von der Mittelposition (Position 0) zu den Positionen +2 oder -2 direkt mit einer Stellgröße verknüpft sein. Wie beim langen Schieberegler ist auch für den Grenzfall N = 2 der Komfort des direkt bedienbaren Schiebereglers nutzbar, insbesondere für relativ kleine Stellbereiche wie etwa eine relative Helligkeitsverstellung einer Leuchtanzeige oder eine relative Lautstärkeverstellung eines akustischen Warnsignals.

Mit dieser Methode ist es aber auch möglich, die fünf unterscheidbaren Positionen der Abbildung 13 mit diskreten Funktionen der verschiedensten Art zu belegen. Die rechnerische Ermittlung der Fingerposition mit einer Genauigkeit von zwei Dezimalstellen (beispielsweise x = 1,43) bleibt bei diesen Anwendungen die gleiche; darüber hinaus wird die Möglichkeit genutzt, feste Punkte oder Bereiche auf der Bedienlinie (-2, -1, 0, +1, +2) als "virtuelle Sensoren" zu definieren und mit diskreten Schaltfunktionen auszustatten. Hierzu werden beispielsweise alle Rechenergebnisse x, die zwischen -0,5 und +0,5 liegen, einem virtuellen Sensor 0 zugeordnet, die zwischen +0,5 und +1,5 liegenden Rechenwerte einem virtuellen Sensor +1, usw.. Die zugehörigen Funktionen spiegeln sich in der Bedruckung Be der Glasplatte G wider. Die Abbildungen 12 und 14 zeigen Beispiele für mögliche Bedruckungen und für zugehörige Funktionen des kleinen Schiebereglers.

In Abbildung 14 ist ganz links eine elementare Bedruckung Be mit "+" und "-" dargestellt, bei der nur zwei der fünf virtuellen Sensoren genutzt werden. Die Funktion "+" steht in diesem Fall für eine schrittweise Erhöhung der Kochstufe. Umgekehrt wird die Kochstufe schrittweise vermindert, so lange der Finger den virtuellen Sensor "-" berührt.

In der Mitte der Abbildung 14 ist ein Beispiel dargestellt, in dem drei der fünf virtuellen Sensoren mit Schaltfunktionen belegt sind. Die Bedruckung Be gilt hier für die Vorwahl einer Garzeit T. Die Funktionen "+" und "-" stehen ähnlich wie zuvor bei der Kochstufe für eine schrittweise Erhöhung oder Verminderung der gerade aktuell eingestellten Garzeit T. Der Wertebereich von T (die zugehörige optische Anzeige ist in Abbildung 14 nicht dargestellt) kann beispielsweise von 0 bis 99 Minuten reichen. In der mit "0" bezeichneten Mittelposition wird der Garzeitzähler auf 0 zurückgestellt, und zwar nicht schrittweise, sondern direkt ohne Zeitverzug. Man kann diesen virtuellen Sensor und seine Funktion daher als "Null-Sensor" bezeichnen.

In diesem Beispiel der Abbildung 14, Mitte können aber auch sämtliche 5 virtuellen Sensoren mit Funktionen belegt sein. Zusätzlich zu dem beschriebenen Null-Sensor in der Mittelposition und zusätzlich zu den benachbarten Sensoren "+" und "-" können die beiden Endpositionen links und rechts mit Funktionen "++" und "--" belegt sein, d. h. der Garzeitzähler T wird in den Endpositionen schneller aufwärts oder abwärts verstellt. Um die Beschleunigung zu erreichen, kann die außen angewählte Funktion entweder die Frequenz oder die Schrittweite erhöhen, mit denen der Zählbereich von 0 bis 99 durcheilt wird. Hier liegt ein Beispiel vor, in dem die Abweichung von der Mittelposition als ein Maß für die Größe der Änderung einer Stellgröße interpretiert wird. Die Funktionszuweisung ähnelt einem Joystick. Je weiter sich der Betätiger von der Mittelposition entfernt, desto schneller ändert sich die Stellgröße. Diese Eigenschaft ist in der Bedruckung gemäß Abbildung 14 durch Keile symbolisiert. Die Keile können alternativ zu den fünf diskreten virtuellen Sensoren auch eine analog-kontinuierliche Joystick-Funktion symbolisieren.

In der Abwandlung gemäß Abbildung 14 rechts ist der virtuelle Sensor in der Mittelposition mit I/O bezeichnet, d. h. er schaltet eine der Kochstellen ein und aus. Das Erhöhen oder Vermindern der Kochstufe dieser Kochstelle kann durch eine ähnliche Signalauswertung geschehen, wie sie für die Garzeiteinstellung in Abbildung 14 Mitte beschrieben wurde. Erste Möglichkeit hierfür (nicht jeder virtuelle Sensor wird benutzt): +1= Erhöhung der Kochstufe, -1= Vermindern der Kochstufe, +2 und -2 sind nicht benutzt. Zweite Möglichkeit: +1= langsame Erhöhung der Kochstufe, +2= schnelle Erhöhung der Kochstufe, -1= langsame Verminderung der Kochstufe, -2= schnelle Verminderung der Kochstufe. Dritte Möglichkeit (zwei virtuelle Sensoren sind mit der gleichen Funktion belegt): sowohl +1 als auch +2= Erhöhung der Kochstufe mit einer bestimmten Geschwindigkeit, sowohl -1 als auch -2= Verminderung der Kochstufe mit einer bestimmten Geschwindigkeit.

Das Konzept der "virtuellen Sensoren" hat den Vorteil, dass die Hardware-Anordnung der drei oder vier optischen Komponenten (Sender und Empfänger gemäß Abbildung 12) sowie die Software für die primäre Berechnung der Fingerposition für eine Vielzahl von unterschiedlichen Konfigurationen der Benutzeroberfläche genutzt werden kann. Je nach Wunsch des Herstellers des Kochfelds braucht nur die Bedruckung der virtuellen Sensoren auf der Bedienlinie angepasst zu werden. So können mit nur drei Bauteilen fünf virtuelle Sensoren geschaffen werden, die bei herkömmlicher Bauweise mindestens sechs Bauteile benötigt hätten. In herkömmlicher Bauweise müssten nämlich drei IR-Sensorpaare (jeweils ein IR-Sender und ein IR-Empfänger bilden in einem Gehäuse ein Paar) nebeneinander gesetzt werden, um mit drei Einzelbetätigungen und drei Doppelbetätigungen auf fünf Sensoren zu kommen.

Die virtuellen Sensoren in der eindeutigen Mittelposition und in den beiden Endpositionen eignen sich besonders gut zur Auslösung spezieller Funktionen. Als spezielle Funktionen kommen in Frage

- ein I/O-Sensor: schaltet eine Kochstelle ein und aus;
- ein Ankochstoß-Sensor: schaltet eine Kochstelle für eine bestimmte Zeit auf die höchste Kochstufe (100% des Stellbereichs);
- ein Boost-Sensor: arbeitet als Ankochstoß-Sensor für eine induktive Kochstelle vorübergehend sogar mit mehr als 100% des einstellbaren Bereichs der Kochstufe;
- ein Null-Sensor: stellt den Zeitzähler (Timer) der Kochstelle auf 0 zurück;
- ein Zweikreis-Sensor: erweitert die Kochstelle um einen zweiten Heizkreis, der in einer Zusatzzone liegt.

Bei den genannten Sensorfunktionen ist es zweckmäßig, die Betätigungszeit, z. B. eine Betätigungszeit von mehr als 1 Sekunde, als zusätzlichen Parameter auszuwerten, um flüchtigen Fehlbedienungen vorzubeugen. Eine lange Betätigungszeit kann die Mittelposition (oder die Endpositionen) auch als Zusatzsensor qualifizieren, d. h. als einen virtuellen Sensor zusätzlich zu einer analogen Bedeutung der Fingerposition bei kurzer Betätigungszeit. Im Beispiel der Abbildung 14 rechts kann ein kurzes Betätigen nahe der Mittelposition zunächst eine sehr langsame Verstellung der Kochstufe hervorbringen, während ein Verweilen von 1 Sekunde oder länger als Abschalten der Kochstelle gedeutet wird.

In Abbildung 15 ist dargestellt, wie die bisher eindimensionale Bedienlinie durch rechtwinkliges Kreuzen von kurzen Schiebereglern zu einem zweidimensionalem Bedienfeld erweitert werden kann. Ausgangspunkt der Erweiterung ist gemäß Abbildung 15a die bevorzugte Ausführungsform des kleinen Schiebereglers mit den drei Komponenten Empfänger/Sender/Empfänger, so wie sie anhand der Abbildung 13 zuvor beschrieben wurde. Unter der Glasplatte ist symbolisch die Anordnung der drei Bauteile dargestellt; über der Glasplatte sind die fünf virtuellen Sensoren symbolisiert, die ganz sicher unterscheidbar sind.

Wenn man zu den drei Bauteilen gemäß Abbildung 15a noch jeweils einen Empfänger oberhalb und unterhalb des Senders bestückt, so entsteht ein Kreuz mit einem Sender in der Mitte und vier Empfängern in jeder Richtung, Abbildung 15b. Aus der eindimensionalen Betätigungslinie mit drei Bauteilen und fünf virtuellen Sensoren wird so eine Betätigungsfläche mit fünf Bauteilen und dreizehn virtuellen Sensoren (Abbildung 15b). Es wird nicht nur ein zweiter Schieberegler gebildet, der senkrecht auf dem ersten steht, sondern es entstehen zwischen den Winkeln des Kreuzes - ohne zusätzliche Bauteile - vier zusätzliche virtuelle Sensoren. Die Messung längs einer Bedienlinie wie in Abbildung 15a funktioniert nämlich auch dann, wenn der Finger nicht genau auf der Bedienlinie, sondern etwas abseits davon positioniert ist.

In den Abbildungen 15c und 15d wird deutlich, wie durch den abwechselnden Einsatz von Sendern und Empfängern eine geschlossene Sensorfläche entsteht, die als Bedienfeld (Touchpad) verwendet werden kann. In Abbildung 15c kommt ein weiterer horizontaler Schieberegler hinzu, diesmal bestehend aus den Bauteilen Sender/Empfänger/Sender. In einem solchen Fall, d. h. sobald mehr als ein optischer Sender vorhanden ist, wird man die Sender nacheinander aktivieren und den Lichteinfall auf die jeweils benachbarten Empfänger messen. Die Auswertung der Signalstärken geschieht zeilenweise und spaltenweise für jeden vollzähligen kleinen Schieberegler, wie beschrieben, durch Berechnung des Verhältnisses S1/S2. Über die Signalverteilung kann daher die Position sowohl in X- als auch in Y-Koordinatenrichtung mit hinreichend großer Genauigkeit berechnet werden.

Das Schachbrettmuster gemäß Abbildung 15d kann, mit nur 3 mal 3 = 9 Komponenten, 5 mal 5 = 25 virtuelle Sensoren abbilden. Dabei bleibt der zugehörige Messvorgang einfach. Bei Aktivierung des zentralen Senders werden die vier benachbarten Empfangssignale gemessen und bei serieller Aktivierung eines der vier Randsender werden jeweils zwei benachbarte Empfangssignale gemessen; insgesamt also zwölf Signalstärken. Auf jeder Bedienlinie wird aus zwei der zwölf gemessenen Signalstärken ein Verhältnis S1/S2 berechnet. Es entstehen sechs Verhältnisse S1/S2, entsprechend den drei horizontalen und den drei vertikalen Schiebereglern.

Die Abbildung 16 zeigt Beispiele dafür, wie die Bedienfelder gemäß Abbildung 15 zur Steuerung von Eingabeparametern verwendet werden können. Trotz der Konzentration der virtuellen Sensoren im Bedienfeld bleibt die Steuerung übersichtlich. Links in der Abbildung 16 wird das kreuzartige Bedienfeld gemäß Abbildung 15b zugrunde gelegt. Die horizontale Bedienlinie ermöglicht eine Einstellung der Garzeit T, so wie sie im Zusammenhang mit der Abbildung 14, Mitte beschrieben wurde. Die vertikale Bedienlinie verstellt die Kochstufe KS und zwar für dasselbe Kochfeld, für das die eingestellte Garzeit T gilt. Falls alle virtuellen Sensoren gemäß Abbildung 15b belegt sind, so ist die in Zusammenhang mit Abbildung 14 beschriebene Joystick-Funktion in beiden Richtungen verwirklicht. Es ist aber auch bei dem zweidimensionalen Bedienfeld wiederum möglich, einzelne virtuelle Sensoren zu isolieren und besonderen Funktionen zuzuordnen. Es entsteht dann eine Mischung aus Schieberegler und einzelnen virtuellen Sensoren. Ein Beispiel hierfür gibt die Abbildung 16 in der zweiten Bedruckung von links. Sie zeigt einen horizontalen Schieberegler + 0 - und einen Kochstelleneinschalter darunter sowie einen Kochstellenausschalter darüber. In den Diagonalen sind Symbole für die vier Kochstellen gedruckt, für deren Auswahl die virtuellen Diagonalsensoren gemäß Abbildung 15b zur Verfügung stehen.

Ein Bedienfeld gemäß Abbildung 15c liegt dem weiteren Bedruckungsbeispiel in Abbildung 16 rechts zugrunde. In der obersten Zeile kann zunächst eine der vier Kochstellen 1, 2, 3 oder 4 angewählt werden. Der Schieberegler + 0 - darunter verstellt dann die Kochstufe. Der Sensor T in der obersten Zeile aktiviert die Garzeiteinstellung für diese Kochstelle, die sich dann ebenfalls durch den darunter liegenden Schieberegler + 0 - einstellen lässt. Schließlich kann die so vorprogrammierte Kochstelle durch den isolierten Sensor mit der Bezeichnung "I" eingeschaltet werden. In diesem Beispiel sind mit nur sieben Bauteilen sehr viele Bedienfunktionen darstellbar.

In Abbildung 16 ganz rechts ist schließlich angedeutet, dass das Bedienfeld, das aus 3 mal 3 = 9 Komponenten besteht und bis zu 25 virtuelle Sensoren ermöglicht, ausgebaut werden kann auf 4 mal 4 = 16 Komponenten mit 7 mal 7 = 49 virtuellen Sensoren usw. Durch Aktivierung der optischen Sender nacheinander können so auch komplexere Funktionen eingegeben werden, die für die Bedienung von Kochfeldern (und von ähnlichen Glasplatten mit Anzeige- und Betätigungsfunktionen) denkbar sind.

## Patentansprüche

1. Kochfeldsteuerung mit einer Mehrzahl von optischen Sendern (Se) und einer Mehrzahl von optischen Empfängern (E), wobei die optischen Sender (Se) und die optischen Empfänger (E) auf einem Träger (T) abwechselnd längs einer Bedienlinie angeordnet sind, wobei die optischen Sender (Se) sichtbares Licht ausstrahlen und jeder optische Empfänger (E) sichtbares Licht, das von einem Betätiger (F), insbesondere einem Finger, reflektiert wird, von einem oder mehreren der optischen Sender (Se) erhalten und darauf reagieren kann, wobei der jeweilige Lichteinfall auf alle optischen Empfänger (E) quantitativ erfasst und daraus eine aktuelle Position des Betätigers (F) auf der Bedienlinie berechnet wird, wobei die Positionsberechnung den Schwerpunkt (X) der Intensitätsverteilung des Lichteinfalls auf allen optischen Empfängern (E) ermittelt, **dadurch gekennzeichnet, dass** die Lichtsender (Se) gleichzeitig als Anzeigeelemente (A) eingesetzt werden, wobei die Mehrzahl der Lichtsender (Se) abhängig von der aktuellen Position des Betätigers (F) auf der Bedienlinie in zwei Gruppen geteilt wird, wobei die eine Lichtsendergruppe zusätzlich zu im Zeitmultiplex für die optischen Empfänger (E), aber nicht für das menschliche Auge, bestimmten Impulsen mit weiteren Impulsen angesteuert wird, welche diese Lichtsendergruppe für das Auge der Bedienperson sichtbar macht.

2. Kochfeldsteuerung nach Anspruch 1, **dadurch gekennzeichnet, dass** die optischen Sender (Se) mit Impulsen angesteuert werden und entsprechende Lichtimpulse aussenden.

3. Kochfeldsteuerung nach Anspruch 2, **dadurch gekennzeichnet, dass** die Mehrzahl der optischen Sender (Se) im Zeitmultiplex nacheinander mit kurzen, für das Auge einer Bedienperson unsichtbaren Impulsen angesteuert wird und dass die Mehrzahl der optischen Empfänger (E) jeweils gleichzeitig für jeden der Sender (Se) aktiviert wird oder zumindest die dem jeweils aktiven Sender (Se) benachbarten Empfänger (E) gleichzeitig aktiviert werden.

4. Kochfeldsteuerung nach einem der vorherigen Ansprüche, **dadurch gekennzeichnet, dass** die Lichtsender (Se) als Anzeigeelemente (A) in Form eines "Bargraph" eingesetzt werden.

5. Kochfeldsteuerung nach einem der Ansprüche 1 bis 4, **dadurch gekennzeichnet, dass** in Zwischenpositionen zwischen der Mehrzahl von optischen Sendern (Se) und Empfängern (E) abwechselnd auf der Bedienlinie der Träger (T) mit Anzeigeelementen (A) bestückt ist, welche eine Wellenlänge im sichtbaren Bereich abstrahlen.

6. Kochfeldsteuerung nach einem der vorhergehenden Ansprüche, **dadurch gekennzeichnet, dass** die optischen Sender (Se) und Empfänger (E) auf der Unterseite des Trägers (T) angeordnet sind und dass die Reflektion des Lichts durch Aussparungen (Au) im Trägermaterial (T) hindurch erfolgt.

7. Kochfeldsteuerung nach Anspruch 6, **dadurch gekennzeichnet, dass** die Aussparungen (Au) im Träger (T) als ein zusammenhängendes Langloch für die Mehrzahl von optischen Sendern (Se) und Empfängern (E) ausgebildet sind.

**8.** Kochfeldsteuerung nach Anspruch 6, **dadurch gekennzeichnet, dass** die Aussparungen (Au) im Träger (T) als Bohrung oder Langloch für jeden optischen Sender (Se) und Empfänger (E) ausgebildet sind.

**9.** Kochfeldsteuerung nach einem der Ansprüche 1 bis 5, **dadurch gekennzeichnet, dass** die optischen Sender (Se) und Empfänger (E) mit kleiner Bauhöhe ohne Lichtleitsockel auf der Oberseite des Trägers (T) angeordnet sind.

**10.** Kochfeldsteuerung nach einem der vorherigen Ansprüche, **dadurch gekennzeichnet, dass** die Kochfeldsteuerung zwei optische Sender (Se) und zwei optische Empfänger (E) aufweist, wobei ein Sender (Se) und ein Empfänger (E) in einem Gehäuse zusammengefasst sind und der zweite Sender (Se) und der zweite Empfänger (E) in einem zweiten Gehäuse so zusammengefasst sind, dass die Gehäuse wechselseitig Lichteinfall durch Streulicht zulassen.

**11.** Kochfeldsteuerung nach Anspruch 10, **dadurch gekennzeichnet, dass** die zwei quantitativ erfassten Signalstärken der optischen Sensoren (S1, S2) zueinander ins Verhältnis gesetzt werden und aus diesem Verhältnis die Schwerpunktsposition des Betätigers (F) berechnet wird.

**12.** Kochfeldsteuerung nach einem der vorherigen Ansprüche, **dadurch gekennzeichnet, dass** die aktuellen Positionen des Betätigers (F) auf der Bedienlinie einen Wertebereich (x) umfassen, der durch eine Skalentransformation so zugeordnet und ausgewertet wird, dass eine Mittelposition auf der Bedienlinie den Positionswert null erhält und eine Abweichung von der Mittelposition nach einer Seite einen negativen Positionswert und eine Abweichung nach der anderen Seite einen positiven Positionswert erhält.

**13.** Kochfeldsteuerung nach Anspruch 12, **dadurch gekennzeichnet, dass** der quasi-kontinuierlich berechnete Positionswert direkt mit einer analogen Stellgrösse verknüpft ist.

**14.** Kochfeldsteuerung nach Anspruch 12, **dadurch gekennzeichnet, dass** der quasi-kontinuierlich berechnete Positionswert einem diskreten Bereich auf der Bedienlinie zugeordnet wird und der Bereich als virtueller Sensor definiert, d.h. mit einer diskreten Schaltfunktion belegt ist.

**15.** Kochfeldsteuerung nach Anspruch 14, **dadurch gekennzeichnet, dass** fünf Bereiche als sicher unterscheidbare virtuelle Sensoren auf der Bedienlinie definiert sind.

**16.** Kochfeldsteuerung nach Anspruch 14 oder 15, **dadurch gekennzeichnet, dass** zur Auslösung einer Schaltfunktion in dem diskreten Bereich der Bedienlinie zusätzlich zu der Signalstärke auch eine Mindestbetätigungszeit des virtuellen Sensors erforderlich ist.

**17.** Kochfeldsteuerung nach einem der Ansprüche 14 bis 16, **dadurch gekennzeichnet, dass** die Funktion eines virtuellen Sensors aus der Gruppe I/O-Sensor, Ankochstoß-Sensor, Boost-Sensor, Null-Sensor, Zweikreis-Sensor, Anwahl der Kochstelle oder Anwahl der Garzeit genommen ist.

**18.** Kochfeldsteuerung nach einem der Ansprüche 14 bis 17, **dadurch gekennzeichnet, dass** nicht jeder virtuelle Sensor mit einer Funktion belegt ist oder dass zwei virtuelle Sensoren mit der gleichen Funktion belegt sind.

**19.** Kochfeldsteuerung nach Anspruch 12, **dadurch gekennzeichnet, dass** die positive oder negative Abweichung von der Mittelposition nach Art einer Joystick-Funktion als Maß für eine positive oder negative Änderungsgeschwindigkeit einer analogen oder diskreten Stellgröße verwendet wird.

**20.** Kochfeldsteuerung nach Anspruch 10, **dadurch gekennzeichnet, dass** zwei oder mehr solcher Zwei-Sensor-Anordnungen, deren optischen Sender (Se) und Empfänger (E) sich abwechselnd längs jeweils einer eindimensionalen Bedienlinie erstrecken, durch Kreuzen der Bedienlinien zu einem zweidimensionalen Bedienfeld erweitert sind.

**21.** Kochfeldsteuerung nach Anspruch 15, **dadurch gekennzeichnet, dass** zwei oder mehr solcher Zwei-Sensor-Anordnungen, deren fünf virtuelle Sensoren sich jeweils längs einer eindimensionalen Bedienlinie erstrecken, durch Kreuzen der Bedienlinien zu einem zweidimensionalen Bedienfeld erweitert sind.

**22.** Kochfeldsteuerung nach Anspruch 21, **gekennzeichnet durch** rechtwinkliges Kreuzen der Bedienlinien und **durch** ein quadratisches Bedienfeld, in dem die optischen Sender (Se) und Empfänger (E) schachbrettartig verteilt sind.

**23.** Kochfeldsteuerung nach Anspruch 21 oder 22, **dadurch gekennzeichnet, dass** zur Auslösung einer Schaltfunktion in dem diskreten Bereich der gekreuzten Bedienlinien zusätzlich zu der Signalstärke auch eine Mindestbetätigungszeit des virtuellen Sensors erforderlich ist.

**Claims**

**1.** Hob controller having a plurality of optical transmitters (Se) and a plurality of optical receivers (E), the optical transmitters (Se) and the optical receivers (E) being alternately arranged along an operator control line on a carrier (T), the optical transmitters (Se) emitting visible light and each optical receiver (E) being able to receive visible light, which is reflected by an actuator (F), in particular a finger, from one or more of the optical transmitters (Se) and being able to react to said light, the respective incidence of light on all optical receivers (E) being quantitatively recorded and being used to calculate a current position of the actuator (F) on the operator control line, the position calculation determining the centroid (X) of the intensity distribution of the incidence of light on all optical receivers (E), **characterized in that** the light transmitters (Se) are simultaneously used as display elements (A), the plurality of light transmitters (Se) being divided into two groups on the basis of the current position of the actuator (F) on the operator control line, one group of light transmitters being controlled, in addition to pulses in time division multiplexing which are intended for the optical receivers (E) but not for the human eye, with further pulses which make this group of light transmitters visible to the operator's eye.

**2.** Hob controller according to Claim 1, **characterized in that** the optical transmitters (Se) are controlled with pulses and emit corresponding light pulses.

**3.** Hob controller according to Claim 2, **characterized in that** the plurality of optical transmitters (Se) are controlled in succession in time division multiplexing with short pulses which are invisible to an operator's eye, and **in that** the plurality of optical receivers (E) are each simultaneously activated for each of the transmitters (Se) or at least the receivers (E) adjacent to the respectively active transmitter (Se) are simultaneously activated.

**4.** Hob controller according to one of the preceding claims, **characterized in that** the light transmitters (Se) are used as display elements (A) in the form of a "bar graph".

**5.** Hob controller according to one of Claims 1 to 4, **characterized in that** the carrier (T) is alternately fitted with display elements (A) on the operator control line in intermediate positions between the plurality of optical transmitters (Se) and receivers (E), which display elements emit a wavelength in the visible range.

**6.** Hob controller according to one of the preceding claims, **characterized in that** the optical transmitters (Se) and receivers (E) are arranged on the underside of the carrier (T), and **in that** the light is reflected through recesses (Au) in the carrier material (T).

**7.** Hob controller according to Claim 6, **characterized in that** the recesses (Au) in the carrier (T) are in the form of a continuous slot for the plurality of optical transmitters (Se) and receivers (E).

**8.** Hob controller according to Claim 6, **characterized in that** the recesses (Au) in the carrier (T) are in the form of a hole or slot for each optical transmitter (Se) and receiver (E).

**9.** Hob controller according to one of Claims 1 to 5, **characterized in that** the optical transmitters (Se) and receivers (E) are arranged with a small overall height on the top side of the carrier (T) without light-guiding bases.

**10.** Hob controller according to one of the preceding claims, **characterized in that** the hob controller has two optical transmitters (Se) and two optical receivers (E), one transmitter (Se) and one receiver (E) being combined in a housing, and the second transmitter (Se) and the second receiver (E) being combined in a second housing in such a manner that the housings allow incidence of light by scattered light in an alternating manner.

**11.** Hob controller according to Claim 10, **characterized in that** the two quantitatively recorded signal strengths of the optical sensors (S1, S2) are related to one another and the centroid position of the actuator (F) is calculated from this relationship.

**12.** Hob controller according to one of the preceding claims, **characterized in that** the current positions of the actuator (F) on the operator control line comprise a range of values (x) which is assigned and evaluated by means of scale transformation in such a manner that a central position on the operator control line is given the position value of zero and a deviation from the central position to one side is given a negative position value and a deviation to the other side is given a positive position value.

13. Hob controller according to Claim 12, **characterized in that** the quasi-continuously calculated position value is directly linked to an analogue manipulated variable.

14. Hob controller according to Claim 12, **characterized in that** the quasi-continuously calculated position value is assigned to a discrete area on the operator control line, and the area is defined as a virtual sensor, that is to say is assigned a discrete switching function.

15. Hob controller according to Claim 14, **characterized in that** five areas are defined as reliably distinguishable virtual sensors on the operator control line.

16. Hob controller according to Claim 14 or 15, **characterized in that**, in order to initiate a switching function in the discrete area of the operator control line, a minimum actuation time of the virtual sensor is also required in addition to the signal strength.

17. Hob controller according to one of Claims 14 to 16, **characterized in that** the function of a virtual sensor is taken from the group consisting of I/O sensor, cooking surge sensor, boost sensor, zero sensor, dual-circuit sensor, selection of the cooking area and selection of the cooking time.

18. Hob controller according to one of Claims 14 to 17, **characterized in that** not every virtual sensor is assigned a function, or **in that** two virtual sensors are assigned the same function.

19. Hob controller according to Claim 12, **characterized in that** the positive or negative deviation from the central position is used, in the manner of a joystick function, as a measure of a positive or negative rate of change of an analogue or discrete manipulated variable.

20. Hob controller according to Claim 10, **characterized in that** two or more such two-sensor arrangements, the optical transmitters (Se) and receivers (E) of which alternately extend along a respective one-dimensional operator control line, are expanded to form a two-dimensional operator control panel by crossing the operator control lines.

21. Hob controller according to Claim 15, **characterized in that** two or more such two-sensor arrangements, the five virtual sensors of which each extend along a one-dimensional operator control line, are expanded to form a two-dimensional operator control panel by crossing the operator control lines.

22. Hob controller according to Claim 21, **characterized by** crossing of the operator control lines at right angles and by a square operator control panel in which the optical transmitters (Se) and receivers (E) are distributed in a chessboard-like manner.

23. Hob controller according to Claim 21 or 22, **characterized in that**, in order to initiate a switching function in the discrete area of the crossed operator control lines, a minimum actuation time of the virtual sensor is also required in addition to the signal strength.

**Revendications**

1. Commande de plaque de cuisson comprenant une pluralité d'émetteurs optiques (Se) et une pluralité de récepteurs optiques (E), les émetteurs optiques (Se) et les récepteurs optiques (E) étant disposés sur un support (T) en alternance le long d'une ligne de commande, les émetteurs optiques (Se) émettant de la lumière visible et chaque récepteur optique (E) pouvant recevoir la lumière visible en provenance d'un ou plusieurs émetteurs optiques (Se) qui est réfléchie par un actionneur (F), notamment un doigt, et y réagir, l'incidence de la lumière respective sur tous les récepteurs optiques (E) étant détectée quantitativement et une position actuelle de l'actionneur (F) sur la ligne de commande étant calculée à partir de cela, le calcul de la position déterminant le barycentre (X) de la distribution de l'intensité de l'incidence de la lumière sur tous les récepteurs optiques (E), **caractérisée en ce que** les émetteurs de lumière (Se) sont simultanément utilisés en tant qu'éléments indicateurs (A), la pluralité d'émetteurs optiques (Se) étant divisée en deux groupes en fonction de la position actuelle de l'actionneur (F) sur la ligne de commande, l'un des groupes d'émetteurs de lumière étant commandé, en plus des impulsions définies en multiplexage temporel pour les récepteurs optiques (E), mais pas pour l'oeil humain, avec des impulsions supplémentaires qui rendent ce groupe d'émetteurs de lumière visible pour l'oeil de l'opérateur.

2. Commande de plaque de cuisson selon la revendication 1, **caractérisée en ce que** les émetteurs optiques (Se) sont commandés avec des impulsions et émettent des impulsions de lumière correspondantes.

3. Commande de plaque de cuisson selon la revendication 2, **caractérisée en ce que** la pluralité d'émetteurs optiques (Se) est commandée successivement en multiplexage temporel avec de courtes impulsions invisibles pour l'oeil d'un opérateur et **en ce que** la pluralité de récepteurs optiques (E) est à chaque fois activée simultanément pour chacun des émetteurs (Se) ou au moins les récepteurs (E) voisins de l'émetteur (Se) à chaque fois actif sont activés simultanément.

4. Commande de plaque de cuisson selon l'une des revendications précédentes, **caractérisée en ce que** les émetteurs optiques (Se) sont utilisés en tant qu'éléments indicateurs (A) sous la forme d'un « bargraphe ».

5. Commande de plaque de cuisson selon l'une des revendications 1 à 4, **caractérisée en ce que** dans des positions intermédiaires entre la pluralité d'émetteurs (Se) et de récepteurs (E) optiques, le support (T) est équipé en alternance sur la ligne de commande d'éléments indicateurs (A) qui émettent une longueur d'onde dans la plage visible.

6. Commande de plaque de cuisson selon l'une des revendications précédentes, **caractérisée en ce que** les émetteurs (Se) et les récepteurs (E) optiques sont disposés sur le dessous du support (T) et **en ce que** la réflexion de la lumière s'effectue à travers des évidements (Au) dans le matériau support (T).

7. Commande de plaque de cuisson selon la revendication 6, **caractérisée en ce que** les évidements (Au) dans le support (T) sont réalisés sous la forme d'un trou oblong contigu pour la pluralité d'émetteurs (Se) et de récepteurs (E) optiques.

8. Commande de plaque de cuisson selon la revendication 6, **caractérisée en ce que** les évidements (Au) dans le support (T) sont réalisés sous la forme d'un perçage ou d'un trou oblong pour chaque émetteur (Se) et récepteur (E) optique.

9. Commande de plaque de cuisson selon l'une des revendications 1 à 5, **caractérisée en ce que** les émetteurs (Se) et les récepteurs (E) optiques sont disposés avec une faible hauteur de profilé sans socle conducteur de lumière sur le dessus du support (T).

10. Commande de plaque de cuisson selon l'une des revendications précédentes, **caractérisée en ce que** la commande de plaque de cuisson présente deux émetteurs optiques (Se) et deux récepteurs optiques (E), un émetteur (Se) et un récepteur (E) étant regroupés dans un boîtier et le deuxième émetteur (Se) et le deuxième récepteur (E) étant regroupés dans un deuxième boîtier de telle sorte que les boîtiers autorisent alternativement l'incidence de la lumière par de la lumière diffusée.

11. Commande de plaque de cuisson selon la revendication 10, **caractérisée en ce que** les deux intensités de signal détectées quantitativement des capteurs optiques (S1, S2) sont mises en rapport l'une avec l'autre et la position du barycentre de l'actionneur (F) est calculée à partir de ce rapport.

12. Commande de plaque de cuisson selon l'une des revendications précédentes, **caractérisée en ce que** les positions actuelles de l'actionneur (F) sur la ligne de commande englobent une plage de valeurs (x) qui est affectée par une transformation d'échelle et interprétée de telle sorte qu'une position centrale sur la ligne de commande reçoit la valeur de position nulle et un écart par rapport à la position centrale vers un côté reçoit une valeur de position négative et un écart vers l'autre côté reçoit une valeur de position positive.

13. Commande de plaque de cuisson selon la revendication 12, **caractérisée en ce que** la valeur de position calculée quasi-continuellement est directement liée avec une valeur de commande analogique.

14. Commande de plaque de cuisson selon la revendication 12, **caractérisée en ce que** la valeur de position calculée quasi-continuellement est associée à une zone discrète sur la ligne de commande et la zone est définie en tant que capteur virtuel, c'est-à-dire qu'une fonction de commutation discrète est affectée à celle-ci.

**15.** Commande de plaque de cuisson selon la revendication 14, **caractérisée en ce que** cinq zones sont définies sur la ligne de commande en tant que capteurs virtuels pouvant être différenciés avec certitude.

**16.** Commande de plaque de cuisson selon la revendication 14 ou 15, **caractérisée en ce que** pour déclencher une fonction de commutation, un temps d'actionnement minimal du capteur virtuel est également nécessaire en plus de l'intensité du signal dans la zone discrète de la ligne de commande.

**17.** Commande de plaque de cuisson selon l'une des revendications 14 à 16, **caractérisée en ce que** la fonction d'un capteur virtuel est prise dans le groupe capteur d'E/S, capteur de démarrage de cuisson, capteur à amplification, capteur de zéro, capteur à double circuit, sélection du point de cuisson ou sélection du temps de cuisson.

**18.** Commande de plaque de cuisson selon l'une des revendications 14 à 17, **caractérisée en ce qu'**une fonction n'est pas affectée à chaque capteur virtuel ou en ce que la même fonction est affectée à deux capteur virtuels.

**19.** Commande de plaque de cuisson selon la revendication 12, **caractérisée en ce que** l'écart positif ou négatif de la position centrale est utilisé à la manière d'une fonction de manette de commande en tant que mesure pour une vitesse de modification positive ou négative d'une grandeur de commande analogique ou discrète.

**20.** Commande de plaque de cuisson selon la revendication 10, **caractérisée en ce que** deux arrangements à deux capteurs ou plus de ce type, dont les émetteurs (Se) et les récepteurs (E) optiques s'étendent en alternance à chaque fois le long d'une ligne de commande unidimensionnelle, sont étendus en un champ de commande bidimensionnel en croisant les lignes de commande.

**21.** Commande de plaque de cuisson selon la revendication 15, **caractérisée en ce que** deux arrangements à deux capteurs ou plus de ce type, dont les cinq capteurs virtuels s'étendent respectivement le long d'une ligne de commande unidimensionnelle, sont étendus en un champ de commande bidimensionnel en croisant les lignes de commande.

**22.** Commande de plaque de cuisson selon la revendication 21, **caractérisée par** un croisement à angle droit des lignes de commande et par un champ de commande quadratique dans lequel les émetteurs (Se) et les récepteurs (E) optiques sont distribués en damier.

**23.** Commande de plaque de cuisson selon la revendication 21 ou 22, **caractérisée en ce que** pour déclencher une fonction de commutation, un temps d'actionnement minimal du capteur virtuel est également nécessaire en plus de l'intensité du signal dans la zone discrète des lignes de commande qui se croisent.

FIG 1

FIG 2

FIG 3

$$X = \frac{\sum\limits_{i=1}^{N} S(i) * i}{\sum\limits_{i=1}^{N} S(i)}$$

FIG 4

Se     E

FIG 5A

FIG 5B

Se; E  T

FIG 5C

A   L  Li

Se; E

T

B

R

FIG 6

A   Se; E

T

B

R

FIG 7

A

FIG 8

Austausch der IR-Sensoren durch Sensoren
deren Wellenlänge im sichtbaren Bereich liegt

FIG 9

Au

FIG 10A

Au

FIG 10B

**Amplitude Sendediode**

SendeLED aktiv und Empfänger aktiv

Zeit

## FIG 11A

SendeLED eingeschaltet und Empfänger aktiv

**Amplitude Sendediode**

SendeLED eingeschaltet und Empfänger ausgeschaltet

Zeit

## FIG 11B

Be                    Be

FIG 12

FIG 13

Be          Be          Be

FIG 14

Virtuelle Sensoren

Bauteile

E Se

a) b) c) d)

## FIG 15

Be Be Be Be

KS +
+ 0 −
KS −

1 2 T 3 4

+ 0 −

G

S S FIG 16 S

S

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10146996 A1
- DE 19700836 C1

- DE 102004024835